# EUROPEAN PATENT APPLICATION

(11) **EP 0 595 620 A1**
(43) Date of publication of application: **04.05.1994**
(21) Application number: 93308573.0
(22) Date of filing: 27.10.1993
(51) Int. Cl.: H03K 17/00

(54) **Switching circuit**

(30) Priority: 27.10.1992 JP 288675/92; 21.12.1992 JP 340262/92; 18.01.1993 JP 6164/93
(71) Applicant: SEIKO INSTRUMENTS INC., Tokyo 136 (JP)
(72) Inventor: Shimoda, Sadashi, Koto-tu, Tokyo (JP)
(74) Representative: Sturt, Clifford Mark

(57) **Abstract**

In the inventive switching circuit, the input terminal (1) and the input terminal (2) are connected to switching transistors (9) and (6) respectively. One of the input voltages is output selectively from the output terminal (5). In order to output selectively one of the input voltages, the voltage detector (7), detects the level of the input voltage of the input terminal (1) so that either the switching transistor (9) or the switching transistor (6) turns on. The voltage of the output terminal (5) is controlled by the voltage controlling circuit (8) because the output signal of the voltage controlling circuit (8) controls the conducting state of the switching transistor (9) so that a stable output voltage can be obtained from the output voltage (9). The voltage controlling circuit is also arranged so as to be driven with a low consuming current, and moreover the chip size can be reduced.

## Description

The present invention relates to a switching circuit constituted of a monolithic IC.

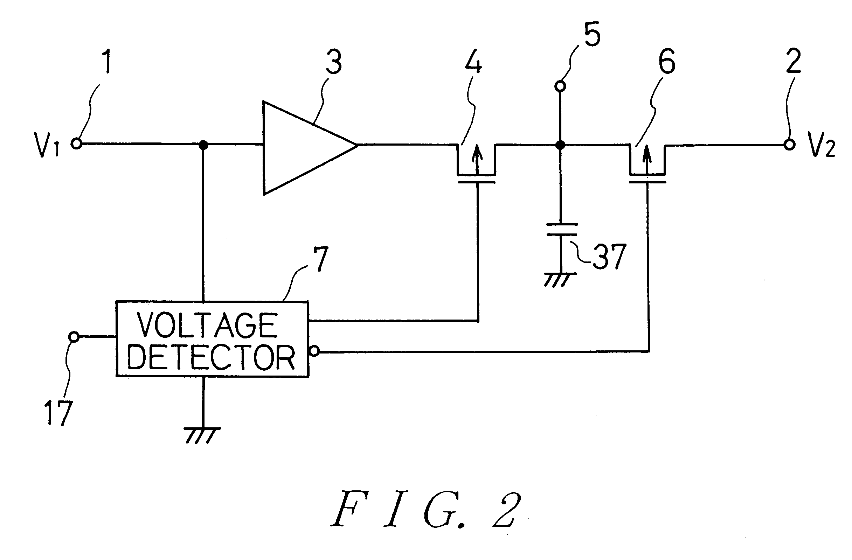

A circuit diagram of a conventional switching circuit is shown in Fig. 2. This is a circuit diagram which is applied when output from a voltage detector 7, connected to an input terminal, is used for changing the input voltage as well as for an interrupt signal when a microcomputer is provided as a load.

First, the operation of the switching circuit when the interrupt signal is not generated will be explained in order to simplify the explanation. V₁ and V₂, which differ from each other, are applied to an input terminal 1 and 2 respectively. The input terminal 1 is connected to an output terminal 5 through a voltage regulator 3 and a switching transistor 4. The other input terminal 2 is also connected to the output terminal 5 through a switching transistor 6. The switching transistors 4 and 6 are switched alternately by the voltage detector 7. For example, voltages V₁ and V₂ are supplied to the input terminals 1 and 2 respectively and the voltage V₁ activates the voltage detector 7. Then, the output of the voltage detector 7 turns on the switching transistor 4 and turns off the switching transistor 6. In this case, the voltage regulated by the voltage regulator 3 is supplied to the voltage terminal 5. In contrast, when the voltage V₁ falls to less than a certain voltage, output of the voltage detector 7 inverts and the switching transistor 4 is turned off and the switching transistor 6 is turned on. Consequently, the voltage V₂ is supplied to the output terminal 5. In other words, a voltage is stably supplied from the output terminal regardless of the variation of the input voltage.

The present invention is directed to a switching circuit which activates stably a system, such as a microcomputer, by means of output from this output terminal.

When an output signal of the voltage detector 7 is used as an interrupt signal to a microcomputer which acts as a load will now be explained. In a microcomputer of a twin clock mode, a high clock mode and a low clock mode are interchanged with each other by this interrupt signal. In order to change the modes, the voltage of the input terminal 1 rises so that the output of the voltage detector 7 inverts. With the rise of the voltage, the output of the voltage detector 7 inverts. As a result, the transistor 4 is turned on and the transistor 6 is turned off. Accordingly, the voltage input from the input terminal 1 is supplied to the output terminal 5. At the same time, the output signal of the voltage detector is also supplied to a signal output terminal 17 and then supplied to the microcomputer as an interrupt signal.

However, the prior art has the following drawbacks. Output voltage from the voltage regulator has a regulated voltage. However since it passes through the switching transistor 4 the voltage drops by as much as the transistor resistance when it is turned on. Thus the dropped voltage is output to the output terminal 5. This voltage drop depends on the quantity of the current flowing in the switching transistor 4 accompanied by a variation of the current consumed by a load such as a microcomputer, and the transistor resistance when it is turned on. Therefore, the output terminal 5 doesn't always output a constant voltage. When current flowing in the switching transistor 4 is large, by as much as tens of million amperes, the size of the switching transistor 4, which is constituted on a monolithic IC, must be relatively large and so the price of the monolithic IC becomes expensive.

As discussed above, when the output terminal 5 is connected to a load, such as a microcomputer, the output signal of the voltage detector 7 is used as a voltage state transmitting signal and particularly, as an interrupt signal. Namely, the microcomputer switches between a high clock mode and a low clock mode. However, when the voltage supplied by the input terminal 1 increases and then the output signal of the voltage detector 7 inverts, the microcomputer is changed to a high clock mode. At the same time, the transistor 4 is turned on, the transistor 6 is turned off, and the output voltage is supplied from the input terminal 1 to the output terminal 5. However, because of a condenser 37, which exists at least practically at the output terminal 5, the time constant of the output terminal 5 becomes larger than the time constant of the input terminal 1. Thus, despite the inadequate voltage which is supplied to the microcomputer connected to the output terminal 5, the microcomputer is changed to a high clock mode. Consequently, the microcomputer gets out of control.

Thus an object of the present invention is to stabilise the output voltage from the output terminal 5 and to reduce the chip size in order to lower costs and prevent the microcomputer from getting out of control.

In order to resolve the aforementioned problems, in the present invention, even if the quantity of current flowing in a switching transistor provided as a switching means, or the resistance value varies when the switching transistor is turn on, the output voltage of the output terminal 5 feedbacks variation thereof to the switching transistor which turn on so as to output precisely a controlled constant voltage. Further, for reducing the size of the IC chip, a voltage regulator provided for feed-back is formed as a circuit which controls voltage of a gate electrode in the switching transistor so that the size of the transistor of the voltage regulator is reducible.

As well, in the present invention, the output state transmitting circuit controls output of the input voltage detector 7. Namely, another voltage detector monitors output of the output terminal 5 and when output of this voltage detector inverts, the output signal of the voltage detector 7 is also inverted so as to prevent from outputting until voltage of the output terminal 5 becomes a minimum operating voltage at which the microcomputer can operate in a high clock mode. Further, by utilising output of the voltage detector 7, consumptive current of a voltage detector 16 connected to the input terminal 2 is cut off so that the switching circuit is constituted of low consumptive current.

The switching circuit of the present invention has a voltage controlling circuit to supply a voltage to the gate of the switching transistor, a current driving capacity of the voltage therefore can be reduced, that is, the size of the voltage controlling circuit can be reduced. Further, voltage controlled very precisely by a feed-back circuit is outputted to the output terminal.

As well, another voltage detector is provided to the output terminal 5, so the voltage value of the output terminal 5 can be always watched. So, if the voltage detector detects that voltage of the output terminal 5 rises to higher than the voltage that the microcomputer gets uncontrollable, output of the voltage detector 7 which is the first means for detecting input voltage inverts so that the microcomputer can be prevented from getting uncontrollable. As well, when an output signal of the voltage detector 7 is given to a transistor in a voltage detector 16 by using output of the voltage detector 7, the consumptive current of the voltage detector 16 which is the second means for detecting input voltage and connected to the input terminal 2 can be cut off.

Embodiments of the present invention will now be described with reference to the accompanying drawings, of which:
Fig. 1 is a diagram showing a switching circuit according to the present invention;
Fig. 2 is a diagram showing a conventional switching circuit;
Fig. 3 is a diagram showing a switching circuit of a second embodiment according to the present invention; and
Fig. 4 is a diagram showing a switching circuit of a third embodiment according to the present invention.

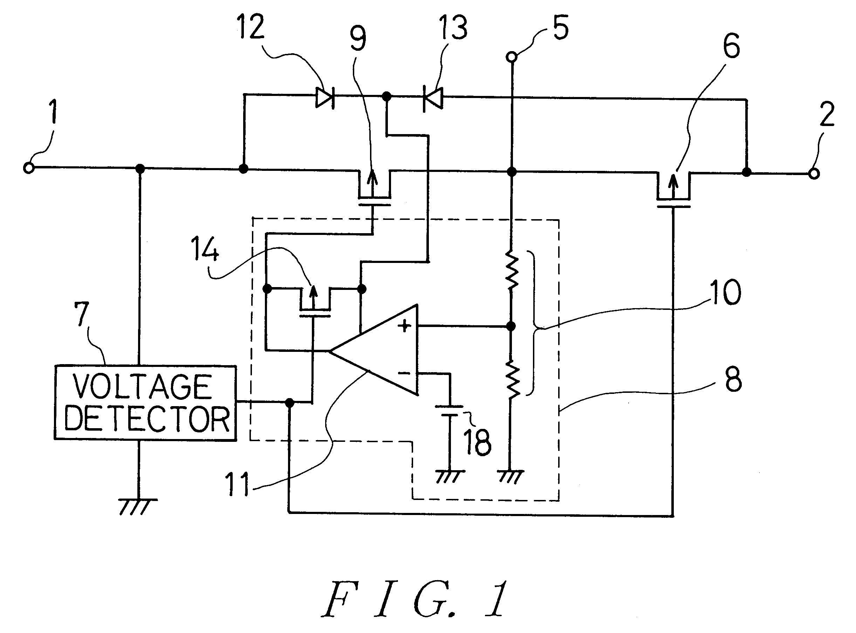

Fig. 1 is a circuit diagram showing the inventive switching circuit in which two input terminals 1, 2 are provided. A voltage detector 7, acting as a means for detecting a level of the voltage of the input voltage, monitors the voltage inputted to the input terminal 1. A switching transistor 9, which is controlled by an output voltage of a voltage controlling circuit 8 and which works as outputting means for output the input voltage to an output terminal 5, is provided between the input terminal 1 and the output terminal 5. A switching transistor 6 is provided between the input terminal 2 and the output terminal 5. A resistance group 10 is connected to the output terminal 5 for dividing the voltage of the output terminal 5. A conjunction of the resistance group is connected to a positive input terminal of a differential amplifier 11. Reference voltage 18 is input to a negative input terminal of the differential amplifier 11. Output of the differential amplifier 11, which is the output for the voltage controlling circuit 8, is connected to a gate of the transistor 9 so as to control whether the transistor 9 is in a conducting state or a non-conducting state. The input terminal 1 and the input terminal 2, which work as means for supplying a power source, are each connected to anodes of a diode 12 and a diode 13 respectively. A positive power source of the differential amplifier 11 is supplied from a conjunction of the diode 12 and the diode 13. The cathodes of the diodes 12, 13 are connected to each other.

The voltage controlling circuit 8 functions as an outputting means for outputting the voltage inputted to the input terminal. Further, the voltage controlling circuit 8 also controls the output voltage at the output terminal 5 so as to be a constant value. A transistor 14 is connected between the conjunction of the diodes 12, 13 and a gate of the transistor 9. The gate of the transistor 14 is connected to an output terminal of the voltage detector 7 and a gate of the switching transistor 6.

An explanation of the operation of the circuit will now be given. Suppose that an input voltage to the input terminal 1 is V₁ and an input voltage to the input terminal 2 is V₂. When the voltage V₁ rises and exceeds a predetermined voltage of the voltage detector 7, an output signal of the output terminal becomes a high voltage level. As a result, the switching transistor 6 is turned off and the voltage controlling circuit 8, comprising the transistor 9, the resistance group 10, the differential amplifier 11 and the transistor 14, regulates the voltage so that a constant voltage is stably outputted to the output terminal 5.

The present invention is characterised in that the voltage controlling circuit 8 controls the gate voltage of the transistor 9, which acts as a switching means. Therefore, the current driving capacity of the voltage controlling circuit 8 can be reduced to a small value. In other words, the size of the voltage controlling circuit 8 can be reduced.

Moreover, the voltage of the output terminal 5 is fedback to the gate electrode of the transistor 9 through the differential amplifier 11 so as to maintain a reference voltage 18. At that time, V₁ or V₂, whichever is higher than the other, will be the voltage outputted to the positive power source of the differential amplifier 11: regardless of the switching operation as the voltage is supplied from the conjunction of the diodes 12 and 13. Therefore, the differential amplifier 11 works stably regardless of the switching operation and load variation.

In contrast, when the voltage V₁ of the input terminal 1 falls and then output of the output terminal of the voltage detector 7 inverts to a low voltage level, the switching transistor 6 is turned on. On the other hand, when the transistor 14 is turned on and then the gate of the transistor 9 gets a high voltage level, the transistor 9 is turned off. Thus, the voltage V₂ of the input terminal 2 is outputted to the output terminal 5 from the cathode electrode.

According to the above explanation, the transistor 9 is turned off by means of the transistor 14. However if, the output signal from the differential amplifier 11 reaches directly to a high voltage level, the output signal of the voltage detector 7 inverts to a low voltage and the transistor 9 can be turned off.

As described in the above embodiment, the voltage detector 7 monitors the voltage V₁ of the input terminal 1. However, the reason why this voltage detector 7 is provided, is to provide a selecting means to indicate the timing to change the two input voltages. Naturally, this does not necessitate monitoring the input terminal 1. The voltage detector 7 can monitor the input terminal 2 depending on the case, or monitor the two voltages by comparison.

For providing the switching means and the selecting means, other arrangements and components than described in the above embodiment can be applied to the present invention. The aforementioned components can be formed of the monolithic IC. Particularly, it is possible to use a schottky diode element for the diodes 12 and 13.

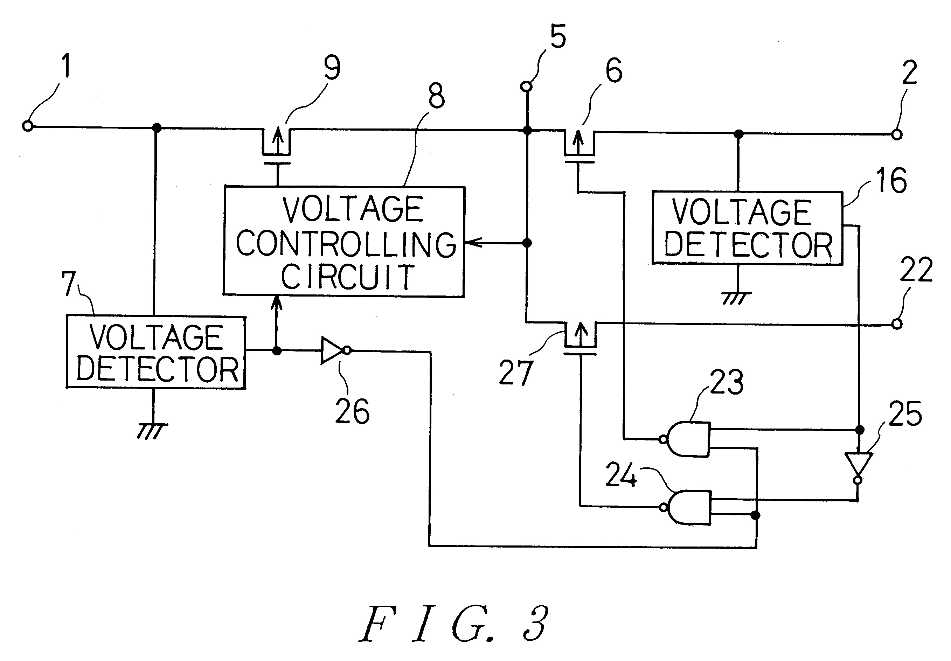

Fig. 3 is a circuit diagram showing the inventive switching circuit wherein three or more voltages interchange. The voltage detector 7 is connected to the input terminal 1 so as to detect the voltage of the input terminal 1. The voltage detector 7 supplies the output signal to an input terminal of a NAND gate 23 and a NAND gate 24 through and an inverter 26. The output signal of the voltage controlling circuit 8 is supplied to the gate electrode of the switching transistor 9 so as to control it's conducting state. Input terminals 1, 2, and 22 are connected to the output terminal 5 through transistors 9, 6, and 27 respectively. A voltage detector 16 is connected to the input terminal 2 so as to detect the input voltage, and the output signal is supplied to one input terminal of the NAND gate 23 and one input terminal of the NAND gate 23 through an inverter 25. Output of the NAND gates 23 and 24 are connected to the gates of the transistors 6 and 27 respectively.

The operation of the circuit will now be described. A main power source is connected to the input terminal 1. The input terminal 2 and the input terminal 22 are connected to a sub power source, such as a primary battery and another sub power source such as a secondary battery respectively. When the voltage of the main power source rises, the output of the voltage detector 7 inverts from a low voltage level to a high voltage level, the transistor 9 is turned on by means of the voltage controlling circuit 8 and the transistors 6 and 27 are turned off through the inverter 26 and the NAND circuits 23 and 24. Consequently, the voltage of the main power source is regulated by the voltage controlling circuit 8 so that a constant voltage is outputted to the output terminal 5.

In contrast, when the main power source drops, the output signal of the voltage detector 7 inverts from a high voltage level to a low voltage level, and the transistor 9 is turned off by the voltage controlling circuit 8. Further, either the transistor 6 or the transistor 27 is turned on by means of the inverter 26 and the NAND circuits 23 and 24. As a result, either voltage of the two sub power sources is outputted to the output terminal 5 through the switching transistor which turns on. At that time, the output voltage forms either voltage of the two sub power sources depending on the voltage detector 16, the inverter 25, the NAND circuits 23 and 24.

When the voltage from the sub power source of a primary battery inputted to the input terminal 2 is higher than the voltage value detected by the voltage detector 16, the output signal of the voltage detector 16 outputs a high level of voltage. Therefore, the inverter 25 and the NAND circuits 23 and 24 turn the transistor 6 on and the transistor 27 off. Consequently, the voltage of a primary battery supplied to the sub power source is outputted to the output terminal 5. On the other hand, when the voltage of a primary battery supplied to the sub power source is lower than the voltage value detected by the voltage detector 16, the output of the voltage detector 16 outputs a low level of voltage. Then the transistor 6 is turned off and the transistor 27 is turned on. At that time, the voltage from the sub power source of a secondary battery input to the input terminal 22 is output to the output terminal 5.

A detecting voltage of the voltage detector 7 is set to higher than the minimum operating voltage of the load, such as the microcomputer, connected to the output terminal 5. For instance, when the microcomputer is operated at 3V ± 10%, the detecting voltage is set to be higher than 2.7 V. On the other hand, a detecting voltage of the voltage detector 16 is set to higher than the minimum memory maintaining voltage of the load, such as SRAM, connected to the output terminal 5. It is usually higher than 2V.

According to the embodiment, P-channel transistors are employed for the transistors 6 and 27. However, N-channel transistors can be also employed on condition that the voltage of the main power source and the sub power source is negative. As well, according to the present invention, the voltage detector 16 is utilised for switching the sub power source of a primary battery and that of a secondary battery. However, the transistors 6 and 27 can be switched on and off by utilising the output of a comparator when it inverts as the voltage value of a primary battery supplied to the sub power source becomes lower than that of a secondary battery supplied to the sub power source on comparing the primary battery of the sub power source with the secondary battery of the sub power source.

In this embodiment, each substrate of the P-channel transistors constituting the transistors 6 and 27 is floating. Alternatively, the substrates of the transistors 6 and 27 can be connected to one transistor electrode on the side of the output terminal 5. When the secondary battery connects to the input terminal 22 so as to be the sub power source, the substrate of the transistor 27 can be connected to one transistor electrode on the side of the input terminal 22.

As shown in the embodiment of Fig. 3, one of the input voltage of the transistors 6, 9, and 27 is output from the three input terminals to the output terminal 5. A selecting means for fixing the conducting state of these three transistors is controlled by the output of the voltage detectors 7 and 16. Particularly, when the number of input terminals is more than three, like this embodiment, it is necessary to provide several voltage detectors for detecting the input voltage of at least two of the input terminals and then to provide selecting means for controlling the conducting state of the transistors acting as switching means by the output voltage of the several voltage detectors. As shown in Fig. 3, it is one of the selecting means that determines which input voltage is selected in the following order: the input terminal 1; the input terminal 2; and the input terminal 22. This is achieved through detecting the desired voltage of each voltage detector. As shown in Fig. 3, a selecting control circuit includes selecting means comprises the voltage controlling circuit 8, the NAND circuits 23 and 24, and the inverters 25 and 26. For the selecting means, the NAND circuits 23 - 24 and the inverters 25 - 26 are provided in the selecting control circuit.

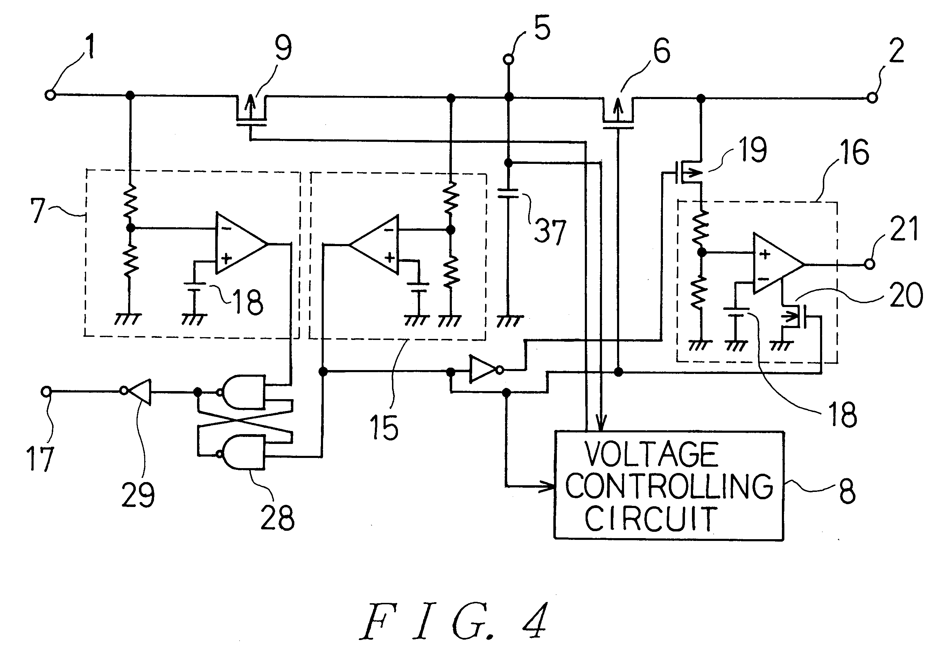

Fig. 4 is a circuit diagram showing another switching circuit of the present invention. According to the embodiment, an output signal of an output state transmitting circuit is outputted from a signal output terminal 17 and used as an interrupt signal to a microcomputer. A resistance group of a voltage detector 7 functioning as a first input voltage detecting circuit is connected to an input terminal 1 so as to detect the voltage of the input terminal 1. The input terminal 1 is connected to an output terminal 5 through a transistor 9 and the input terminal 2 is connected to the output terminal 5 through a transistor 6. A resistance group of a voltage detector 15 is connected to the output terminal 5 so as to detect the voltage of the output terminal 5. A resistance group of a voltage detector 16 functioning as a second input voltage detecting circuit is connected to the input terminal 2 through a transistor 19 so as to detect the voltage of the input terminal 2. Both outputs of the voltage detector 7 and that of the voltage detector 15 are input to a latch circuit 28 and the output signal of which is used as the interrupt signal from the signal output terminal 17.

Further, the output signal of the voltage detector 15 is input to a gate of a transistor 20 which is incorporated into a part of a power source line of a comparator in the voltage detector 16. Similarly to Fig. 1, an output signal of a voltage controlling circuit 8 and that of the voltage detector 7 are connected to a gate of a transistor 9 and that of the transistor 6 respectively. The output state transmitting circuit comprises the latch circuit 28 and an inverter 29. In the output state transmitting circuit, both outputs of the voltage detectors 7 and 15 are input to the latch circuit 28 so that an interrupt signal is output from the inverter 29. In other words, the output signal of the inverter 29 is output as the interrupt signal from the signal output terminal 17.

The operation of the circuit will now be described. A main power source is connected to the input terminal 1 and a sub power source is connected to the input terminal 2. Either voltage of the main power source and the sub power source is selectively output to the output terminal 5 in response to a signal from the voltage controlling circuit 8. For example, when the signal from the voltage controlling circuit 8 is used to turning on the transistor 9 and off the transistor 6, the voltage of the main power source is output to the output terminal 5. In an opposite case, the voltage of the sub power source is output to the output terminal 5.

Now, the case will be considered when the voltage of the main power source rises and the transistor 9 and the transistor 6 turns on and off respectively. The voltage detector 7 inverts its output to a high level of voltage when the main power source rises to, for example, about 4 V. Then the voltage detector 15 inverts its output to a low level of voltage when the voltage of the output terminal 5 rises to, for example, about 3 V. If the main power source is supplied to the input terminal 1, the voltage of the input terminal 1 rises rapidly. In this case, because of a time constant circuit comprising a condenser 37 connected to the transistor 9 and the output terminal 5, the voltage of the output terminal 5 rises more slowly than the voltage of the input terminal 1 does.

In the aforementioned case, the output signal of the voltage detector 7 changes before that of the voltage detector 15 changes. At that time, the signal output terminal 17 maintains a low voltage level since the latch circuit is provided in the output state transmitting circuit. Therefore, the output state transmitting circuit indicates that the output is still a low voltage. Thereafter, when the voltage of the output terminal 5 rises to about 3 V at a time constant evaluated by the resistance of the transistor 9 which is turned on and the condenser 37, the output signal of the voltage detector 15 inverts to a low voltage level. Therefore, the output of the signal output terminal 17 at that time inverts to a high level of voltage. In other words, after the voltage of the output terminal 5 rises to higher than 3 V, the signal output terminal 17 outputs a signal indicating that the output state is a high voltage.

Conversely, when the voltage of the main power source falls, the voltage detector 7 inverts to a low level of voltage in the vicinity of 4 V prior to the voltage detector 15. Hence, the signal output terminal 17 at that time inverts to a low level of voltage. It is preferable that the voltage value of the output inversion of the voltage detector 7 is set higher than the output voltage value of the voltage controlling circuit by about 0.5 - 2.5 V. As well, it is preferable that the voltage value of the output inversion of the voltage detector 15 is set to higher than the maximum value of the voltage at which a microcomputer gets out of control.

The inversion signal of the output of the voltage detector 7 is input to a gate of the transistor 19 which is incorporated in part of the resistance group of the voltage detector detecting the voltage of the sub power source. Thus, when the voltage of the main power source supplied to the input terminal 1 rises, the output of the voltage detector 7 inverts to a high level of voltage, the transistor 19 is turned on and therefore a voltage is generated at the middle point of the resistance group. Further, a comparator in the voltage detector 16 is supplied with a power source. As the transistor 19 is turned on, then the voltage detector 16 starts to operate. In this state, the voltage detector 16 monitors the voltage of the sub power source and then inverts its output according to the voltage drop of the sub power source so as to transmit the voltage of the sub power source through the signal output terminal 21. Conversely, when the output of the voltage detector 16 receives a low level of voltage, the circuit current of the voltage detector 16 is cut off and so the voltage detector 16 ceases to operate.

In general, a primary or secondary lithium battery is widely used for the sub power source. Thereby it is preferable that the inversion voltage of the voltage detector 16 is set to between 2.4 V and 2.8 V.

In this embodiment, means for cutting the circuit current of the voltage detector 16 is illustrated using the transistors 19 and 20. However, other cutting means can be employed if the circuit current of the voltage detector 16 can be cut off when the voltage of the main power source falls to less than a certain constant voltage. Further, in this embodiment, the voltage detector 16 comprises the resistance group, a reference voltage 18, and the comparator. However, the circuit configuration is not restricted to the above. Any voltage detector having a different configuration from the above can be basically used, if it can detect an arbitrary voltage. Further, the positive power sources of each voltage detector, the latch circuit, and the inverters can be supplied from either the main power source or the sub power source. The voltage can be supplied to every voltage detector, the latch circuit, and the inverters or some of them from the point where the cathodes of two diodes are connected to each other and in which the main power source and the sub power source are connected to the anodes respectively. As well, the present invention can also apply when three or more voltages are interchanged so that one output terminal outputs one of these the voltages which has been input.

The output state transmitting circuit can comprise another configuration other than that comprising the latch circuit and the inverter. A main function of that is to indicate an output state in response to output of the output terminal 5. However, if only a signal of the voltage detector 15 acting as a voltage detecting circuit is used, the interrupt signal gets unstable as the load varies. So, in the present invention, the interrupt signal is generated from the output state transmitting circuit by both outputs from the input voltage detecting circuit and the output voltage detecting circuit. Thus, the interrupt signal, that is, the output state transmitting signal, can be stably generated regardless of any variation of input or output.

As mentioned above, according to the present invention, the switching circuit wherein two or more input voltages are interchanged so as to output one voltage among the above voltages to the output terminal, has a switching function through the gate electrode of the switching transistor. Therefore, the chip size of the switching circuit fabricated on a monolithic IC can be greatly reduced so that the switching circuit can be provided at low cost.

## Claims

1. A switching circuit for outputting an output voltage at an output terminal (5) from a number of input voltages inputted at input terminals (1, 2, 21, 22), comprising:
a first voltage detecting means (7) for detecting the voltage level of input voltage inputted from a first input terminal (1);
a first switching means (9) for outputting to the output terminal the input voltage from the first input terminal according to an output signal of the voltage detecting means (7);
a second switching means (6) for outputting to the output terminal the input voltage from the second input terminal (2), and characterised by a voltage controlling means (8) for controlling a conducting state of the first switching means according to the output voltage outputted at the output terminal.

2. A switching circuit according to claim 1, wherein power for the voltage controlling means (8) is supplied from an input voltage selecting means (12, 13) for selecting one of the input voltages.

3. A switching circuit as claimed in claim 1, further comprising a second voltage detecting means (16) for detecting the input voltage inputted from the second input terminal.

4. A switching circuit as claimed in claim 3, further comprising a third switching means (27) for outputting to the output terminal a voltage inputted from a third input terminal (22); and
a selecting gate means (23, 24, 25) for selecting to output to the output terminal either one of the second input voltage and the third input voltage by using output signals of the first voltage detecting means and the second detecting means.

5. A switching circuit as claimed in claim 1 or 3, further comprising a third voltage detecting means (15) for detecting the output voltage outputted to the output terminal; and
an output voltage monitoring means (28, 29) for detecting variations of the output voltage at the output terminal according to output signals of the first voltage detecting means and the third detecting means.

6. A switching circuit as claimed in any one of claims 3, 4 or 5, in which the output signal of the first voltage detecting means (7) controls an operation of the second voltage detecting means (16).

7. A method of operating a switching circuit as claimed in claim 1, comprising:
(a) supplying a first input voltage and a second input voltage to each of the first input terminal (1) and a second input terminal (2);
(b) detecting the first input voltage inputted to the first input terminal;
(c) selecting to switch on either one of a first switching means (9) connected to the first input terminal or a second switching means (6) connected to the second input terminal and outputting the output voltage to the output terminal (5); and
(d) controlling a conducting state of the first switching means (9) according to the output voltage.
